# DEMANDE DE BREVET EUROPEEN

(11) **EP 3 425 800 A1**
(43) Date de publication de la demande: **09.01.2019**
(21) Numéro de dépôt: 18181859.2
(22) Date de dépôt: 05.07.2018
(51) Int. Cl.: H03K 17/0814

(54) **DISPOSITIF DE COMMUTATION POUR TRANSISTOR SIC OU GAN MOSFET AVEC CIRCUIT DE PROTECTION CONTRE LES SURTENSIONS ET PROCÉDÉ ASSOCIÉ**

(30) Priorité: 06.07.2017 FR 1756375
(71) Demandeur: ALSTOM Transport Technologies, 93400 Saint-Ouen (FR)
(72) Inventeur: AL KAYAL, Fisal, 1780 WELMMEL (BE)
(74) Mandataire: Lavoix

(57) **Abrégé**

L'invention concerne un dispositif de commutation de puissance (10) comprenant :
- un transistor (12) du type SiC ou GaN MOSFET présentant à ses bornes une tension principale (U_{c}), et
- un circuit de protection (16) comprenant un module d'écrêtage (18) configuré pour écrêter la tension principale (U_{c}) lorsque le transistor est en surtension et lorsque la tension principale (U_{c}) dépasse alors une tension nominale (U_{N}) prédéterminée,
le circuit de protection (16) comprenant également un module de mesure (20) configuré pour mesurer la tension principale (U_{c}) aux bornes du transistor (12), un réservoir (22) configuré, en charge, pour stocker l'énergie de surtension du transistor (12) et, en décharge, pour délivrer l'énergie de surtension du transistor (12), et un module de contrôle de tension (26) configuré pour commuter le réservoir (22) entre charge et décharge en fonction de la valeur de la tension principale (U_{c}) mesurée.

## Description

La présente invention concerne un dispositif de commutation de puissance comprenant un transistor du type SiC ou GaN MOSFET et un circuit de protection comprenant un module d'écrêtage configuré pour écrêter la tension principale lorsqu'elle dépasse une tension nominale du transistor.

De manière connue en soi, un transistor du type SiC ou Gan MOSFET (respectivement, de l'anglais «*Silicon Carbide*», «*Gallium Nitride*» et « *Métal Oxide Semiconductor Field Effect Transistor* ») appelé également transistor à effet de champ à grille isolée, comprend trois bornes ou contacts électriques, à savoir une grille, un drain et une source.

En particulier, un transistor du type SiC ou Gan MOSFET est utilisable comme interrupteur électrique. En effet, un tel transistor définit un état passant dans lequel le drain est connecté électriquement à la source et un état bloqué dans lequel le drain et la source sont isolés électriquement l'un de l'autre.

La commutation entre les deux états est pilotée par une tension de consigne appliquée sur la grille par des moyens de commande adaptés.

Généralement, le fonctionnement d'un transistor du type SiC ou Gan MOSFET est contrôlé par un dispositif de commutation adapté permettant notamment de protéger le transistor d'une surtension dU.

Si la somme de la surtension dU et de la tension de départ (i.e. tension de bus) dépasse la tension nominale (i.e. tenue en tension) du transistor, celui peut être sérieusement endommagé.

Une telle surtension dU est particulièrement susceptible d'apparaitre si la vitesse de commutation du transistor dl/dt (i.e. la variation de courant par rapport au temps) est élevée ou si l'inductance L du circuit électrique du transistor est élevée.

En effet, la surtension dU est égale au produit de la vitesse de commutation dl/dt et de l'inductance L : dU= dl/dt x L.

Il est néanmoins avantageux de fonctionner à des vitesses de commutation, et donc à des fréquences de commutation, élevées. Ceci permet en effet de réduire le volume, le poids et le coût des composants utilisés dans un dispositif de commutation mais aussi de réduire les pertes d'énergie par commutation.

Pour protéger le transistor d'une surtension en fonctionnement haute fréquence, les dispositifs de commutation existants utilisent un circuit de protection qui écrête la tension aux bornes du transistor.

Toutefois, les dispositifs de commutation existants ainsi que les procédés de commutation mis en oeuvre par ces dispositifs, ne sont pas complètement satisfaisants.

En effet, pour les dispositifs existants, les pertes d'énergie électrique sont élevées.

La présente invention a pour but de proposer un dispositif de commutation permettant de réduire les pertes d'énergies d'un transistor Sic ou Gan MOSFET présentant une vitesse de commutation élevée.

À cet effet, l'invention a pour objet un dispositif de commutation de puissance comprenant :
- un transistor du type SiC ou GaN MOSFET présentant à ses bornes une tension principale, et
- un circuit de protection comprenant un module d'écrêtage configuré pour écrêter la tension principale lorsque le transistor est en surtension et lorsque la tension principale dépasse alors une tension nominale prédéterminée,
le circuit de protection comprenant également un module de mesure configuré pour mesurer la tension principale aux bornes du transistor, un réservoir configuré, en charge, pour stocker l'énergie de surtension du transistor et, en décharge, pour délivrer l'énergie de surtension du transistor, et un module de contrôle de tension configuré pour commuter le réservoir entre charge et décharge en fonction de la valeur de la tension principale mesurée.

Suivant d'autres aspects avantageux de l'invention, le procédé comprend une ou plusieurs des caractéristiques suivantes, prise(s) isolément ou suivant toutes les combinaisons techniquement possibles :
- le dispositif comprend en outre, un module de pilotage configuré pour piloter le transistor, le réservoir étant configuré, en décharge, pour alimenter le module de pilotage en énergie électrique ;
- le module de pilotage comprend une alimentation auxiliaire, configurée pour participer au moins en partie au démarrage du module de pilotage ;
- le dispositif comprend en outre un module de régulation configuré pour réguler, en décharge, la valeur de l'énergie électrique délivrée par le réservoir au module de pilotage ;
- le module de régulation comprend un régulateur linéaire ;
- le module de régulation comprend une alimentation à découpage ;
- le module de contrôle de tension est configuré pour commuter le réservoir en charge lorsque la tension principale mesurée est supérieure à la tension nominale et en décharge lorsque la tension principale mesurée est inférieure à la tension nominale ;
- le dispositif comprend en outre un interrupteur agencé en série du réservoir et la commutation entre la charge et la décharge du réservoir par le module de contrôle de tension correspond à une modification d'une position de l'interrupteur entre une position fermée et une position ouverte ;
- en charge, le réservoir est agencé parallèlement au transistor.

L'invention a également pour objet un procédé de commutation d'un réservoir d'un dispositif de commutation de puissance entre un état en charge et un état en décharge, le dispositif de commutation de puissance comprenant :
- un transistor du type SiC ou GaN MOSFET présentant à ses bornes une tension principale,
- un circuit de protection comprenant :
   - un module d'écrêtage configuré pour écrêter la tension principale lorsque le transistor est en surtension et lorsque la tension principale dépasse alors une tension nominale prédéterminée;
   - un module de mesure configuré pour mesurer la tension principale aux bornes du transistor,
   - un réservoir configuré, en charge, pour stocker l'énergie de surtension du transistor et, en décharge, pour délivrer l'énergie de surtension du transistor, et
   - un module de contrôle de tension configuré pour commuter le réservoir entre charge et décharge,
   le procédé comprenant les étapes suivantes :
   - mesure de la tension principale aux bornes d'un transistor par le module de mesure ;
   - comparaison, par le module de contrôle de tension de la tension principale mesurée à la tension nominale prédéterminée du transistor ;
   - si la tension principale mesurée est supérieure à la tension nominale, activation de la charge du réservoir, par le module de contrôle de tension et, simultanément à la charge du réservoir, écrêtage de la tension principale à une tension d'écrêtage, par le module d'écrêtage ;
   - si la tension principale est inférieure à la tension nominale, activation de la décharge du réservoir, par le module de contrôle de tension.

Ces caractéristiques et avantages de l'invention apparaitront à la lecture de la description qui va suivre, donnée uniquement à titre d'exemple non limitatif, et faite en référence aux dessins annexés, sur lesquels :
- la figure 1 est une vue schématique d'un dispositif de commutation de puissance selon un mode de réalisation de l'invention ; et
- la figure 2 est un organigramme d'un procédé de commutation d'un réservoir mise en oeuvre par le dispositif de commutation de la figure 1.

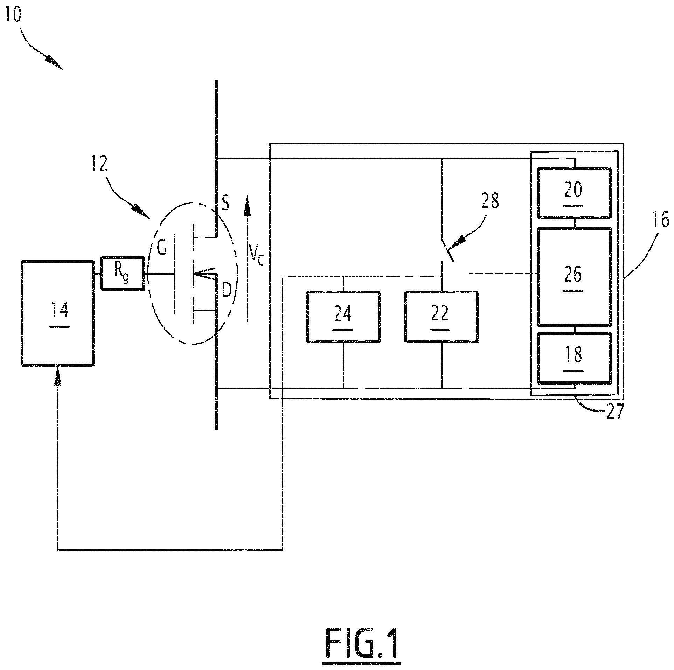

On a représenté sur la figure 1 une vue schématique d'un dispositif de commutation de puissance 10 destiné à convertir l'énergie électrique.

Le dispositif de commutation de puissance 10 est notamment utilisable dans le domaine ferroviaire et est, par exemple, embarqué dans un véhicule ferroviaire.

Le dispositif de commutation 10 comprend un transistor 12, un module de pilotage 14 et un circuit de protection 16.

Le transistor 12 est un transistor du type SiC ou GaN MOSFET (de l'anglais, respectivement, «*Silicon Carbide*», «*Gallium Nitride*» et « *Métal Oxide Semiconductor Field Effect Transistor* ») appelé également transistor à effet de champ à grille isolée.

Le transistor 12 est connu en soi et comporte en particulier trois bornes ou contacts électriques, à savoir, une grille G, un drain D et une source S.

Le transistor 12 définit un état passant dans lequel une tension électrique U_{C}, appelée par la suite tension principale, s'établie entre le drain D et la source S et un état bloqué dans lequel le drain D est isolé électriquement de la source S.

Le transistor 12 présente une tension nominale prédéterminée U_{N} par exemple égale à 600 Volts. Si la tension U_{C} est supérieure à la tension nominale U_{N} pendant une durée prolongée alors le transistor 12 peut être endommagé.

Le transistor est dit en surtension lorsque la tension principale U_{C} est supérieure à la tension nominale U_{N}.

Le module de pilotage (ou allumeur) 14 est connecté à la grille G du transistor 12 via une résistance de grille Rg, et est apte à piloter le fonctionnement de ce transistor 12 en appliquant une tension de consigne et un courant de consigne sur la grille G.

Le circuit de protection 16 est configuré pour protéger le transistor 12 des surtensions.

Le circuit de protection 16 comprend un module d'écrêtage 18, un module de mesure 20, un réservoir 22, un module de régulation 24 et un module de contrôle de tension 26.

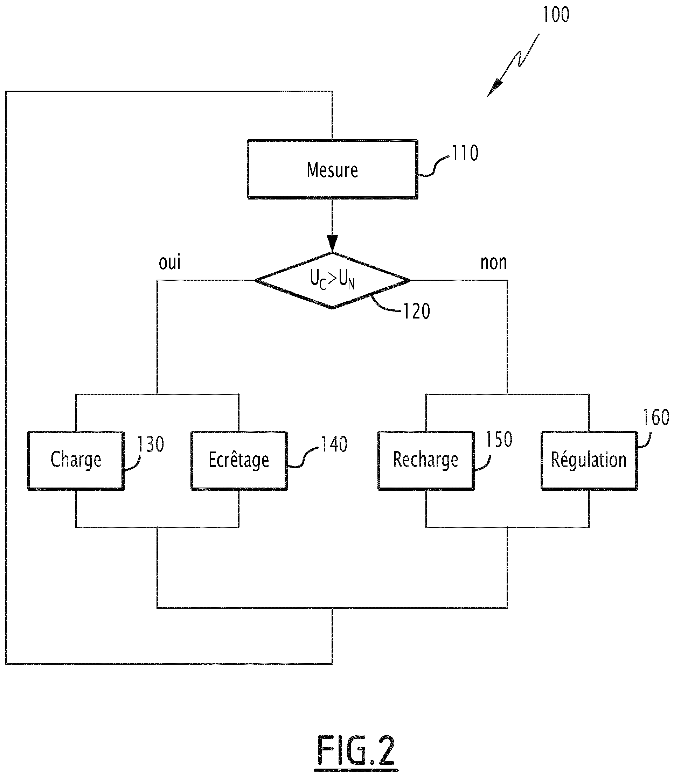

Le circuit de protection 16 est apte à mettre en oeuvre un procédé de commutation 100 du réservoir 22, décrit plus en détail par la suite en relation avec la figure 2.

Le module d'écrêtage 18, le module de mesure 20 et un module de contrôle de tension 26 peuvent être disposés dans un même boitier 27.

Le module d'écrêtage 18 est configuré pour écrêter la tension principale U_{c} à une tension d'écrêtage U_{ecr} lorsque la tension principale U_{c} dépasse la tension nominale prédéterminée U_{N}.

Avantageusement, la valeur de la tension d'écrêtage U_{ecr} est comprise entre 25% et 50% de la tension nominale U_{N}.

Le module d'écrêtage 18 comprend, par exemple, une diode Zener agencée parallèlement au transistor 12.

Le module de mesure 20 est configuré pour mesurer la tension principale U_{C} aux bornes du transistor.

En particulier, le module de mesure 20 est propre à détecter une surtension dU(t) à un instant t (i.e. U_{c}(t) > U_{N}, dU(t)=U_{N}-U_{C}(t)) dans le transistor 12.

Le réservoir 22 est configuré pour être alternativement chargé ou déchargé.

Durant la charge (i.e. avec *t* compris en t₀ l'instant de début de charge et t_{f} l'instant de fin de charge), le réservoir 22 est chargé par la différence de tension entre la tension principale U_{c}(t) et la tension d'écrêtage U_{ecr} avec U_{ecr}≤ U_{N}. En d'autres termes, le réservoir 22 stocke une énergie de surtension issue de l'écrêtage.

Par exemple, pour une tension principale U_{c} de 1500V, une tension d'écrêtage de 1000V, un courant parcourant le transistor de 1A et une durée moyenne de charge de 100ns de surtension par commutation, l'énergie de surtension stockée à chaque commutation est, par exemple, égale à (1500V - 1000V) x 1A x 100ns soit 50 µJ.

Le réservoir 22 comprend, par exemple, un condensateur, de préférence un condensateur en céramique, agencé parallèlement au transistor 12 en charge et agencé parallèlement au module de pilotage 14 en décharge.

Le module de régulation 24 est configuré pour réguler, en décharge, la valeur de l'énergie électrique délivrée par le réservoir 22 au module de pilotage 14. En d'autres termes, le réservoir d'énergie 22 est connecté au module de pilotage 14 à travers le module de régulation qui permet une adaptation du niveau de tension issu du réservoir 22 pour alimenter le module de pilotage 14.

En particulier, lorsque la puissance disponible délivrée par le réservoir 22 en décharge, telle qu'exprimée précédemment, est supérieure à la puissance consommée par le module de pilotage 14 alors le module de régulation 24 est configuré pour dissiper une partie de la puissance disponible.

Le module de régulation 24 comprend, par exemple, un régulateur linéaire ou une alimentation à découpage DC/DC.

L'énergie stockée par seconde, qui représente une puissance disponible pour le module de pilotage 14, varie en fonction de la fréquence de commutation (i.e. fréquence de découpage) du transistor 12.

La puissance disponible, pour une fréquence de commutation de 15kHz et une énergie stockée, à chaque commutation entre charge et décharge du réservoir 22, de 50µJ, est égale à 50µJ x 15kHz soit 0,75 W.

Durant la décharge, le réservoir 22 se décharge de l'énergie de surtension stockée de sorte à alimenter, au moins en partie, le module de pilotage 14.

Si la puissance disponible, pour une fréquence de commutation donnée du transistor 12, est inférieure à la puissance consommée par le module de pilotage 14, alors l'alimentation haute tension (non représentée) du module de pilotage 14 n'est pas complètement supprimée.

A l'inverse, si la puissance disponible pour une fréquence de commutation donnée du transistor 12, est supérieure à la puissance consommée par le module de pilotage 14, alors une partie de cette puissance disponible est dissipée.

De préférence, le module de pilotage 14 comprend également une alimentation auxiliaire allégée (i.e. dont le poids et/ou l'encombrement sont réduits par rapport au module de pilotage des dispositifs de commutation de puissance existants), non représentée, afin de garantir son propre démarrage.

Le module de contrôle de tension 26 est connecté au module de mesure 20 pour récupérer les mesures de la tension principale U_{c}.

Le module de contrôle de tension 26 est configuré pour contrôler, par commutation, le cheminement de l'énergie de surtension du transistor 12 au réservoir 22 et du réservoir 22 au module de pilotage 14.

Le module de contrôle de tension 26 est donc propre à commuter le réservoir 22 entre la charge et la décharge en fonction de la valeur de la tension principale mesurée.

Pour ce faire, le module de contrôle de tension 26 contrôle un interrupteur 28 agencé en série avec le réservoir 22, la commutation entre la charge et la décharge du réservoir 22 par le module de contrôle de tension 26 correspondant à une modification d'une position de l'interrupteur 28 entre une position fermée et une position ouverte.

Le fonctionnement du procédé de commutation 100 du réservoir 22 sera désormais expliqué en référence à la figure 2.

Lors d'une première étape 110, le module de mesure 20 mesure la tension principale aux bornes du transistor 12.

Puis, selon une étape 120, le module de contrôle de tension 26 compare la tension principale mesurée à la tension nominale U_{N} prédéterminée du transistor 12.

Si la tension principale mesurée est supérieure à la tension nominale U_{N}, autrement dit si le transistor 12 est en surtension, le module de contrôle de tension 26 ferme l'interrupteur 28. Le réservoir 20 est alors en charge selon une étape 130.

Comme illustrée par la figure 2, simultanément à l'étape 130, le module d'écrêtage 18 exécute en parallèle une étape d'écrêtage 140 de la tension principale à la tension d'écrêtage U_{ecr}. En d'autres termes, le réservoir est chargé par la différence entre la tension principale et la tension d'écrêtage U_{ecr}.

Dans le cas contraire, si la tension principale est inférieure à la tension nominale U_{N}, le module de contrôle de tension 26 ouvre l'interrupteur 28 et le réservoir 22 bascule en décharge à l'étape 150. Le réservoir 22 réinjecte (i.e. délivre) alors l'énergie de surtension stockée vers le module de pilotage 14.

Simultanément à l'étape 150, selon l'étape 160, le module de régulation 24 régule en parallèle l'énergie de surtension délivrée en décharge par le réservoir 22 au module de pilotage 14.

Le processus 100 est réitéré à chaque détection de surtension et inversement. Ainsi, le réservoir 22 bascule automatiquement entre la charge et la décharge en fonction du signe de la différence entre la tension principale et la tension nominale U_{N}. Cet asservissement permet d'alimenter de manière régulée le module de pilotage 14 en énergie électrique.

On conçoit alors que la présente invention présente un certain nombre d'avantages.

Le procédé de commutation selon l'invention permet d'augmenter la vitesse de commutation dl/dt du transistor 12 sans risquer de surtension et sans pour autant augmenter les pertes d'énergie.

La vitesse de commutation du transistor 12 peut être accélérée en réduisant la résistance Rg de la grille G ou en augmentant la valeur de la tension de consigne générée par le module de pilotage 14 apte à faire commuter le transistor 12 d'un état passant à un état boqué.

Par ailleurs, l'alimentation haute tension (non représentée) du module de pilotage 14 est allégée, voire supprimée le cas échéant, ce qui améliore la fiabilité du module de pilotage 14 et en réduit le volume.

En particulier, l'utilisation d'un condensateur de découplage sur le module de pilotage 14 n'est plus nécessaire.

Ceci est particulièrement avantageux pour les transistors de type Sic MOSFET.

Il est à noter que les contraintes concernant l'inductance L du circuit électrique dans lequel le transistor 12 est utilisé sont levées puisque le risque de surtension est écarté, permettant ainsi de simplifier les exigences imposées au circuit électrique.

## Revendications

1. Dispositif de commutation de puissance (10) comprenant :
- un transistor (12) du type SiC ou GaN MOSFET présentant à ses bornes une tension principale (U_{c}), et
- un circuit de protection (16) comprenant un module d'écrêtage (18) configuré pour écrêter la tension principale (U_{c}) lorsque le transistor est en surtension et lorsque la tension principale (U_{c}) dépasse alors une tension nominale (U_{N}) prédéterminée,
**caractérisé en ce que** le circuit de protection (16) comprend également un module de mesure (20) configuré pour mesurer la tension principale (U_{c}) aux bornes du transistor (12), un réservoir (22) configuré, en charge, pour stocker l'énergie de surtension du transistor (12) et, en décharge, pour délivrer l'énergie de surtension du transistor (12), et un module de contrôle de tension (26) configuré pour commuter le réservoir (22) entre charge et décharge en fonction de la valeur de la tension principale (U_{c}) mesurée.

2. Dispositif de commutation de puissance (10) selon la revendication 1, dans lequel le dispositif comprend en outre, un module de pilotage (14) configuré pour piloter le transistor (12), le réservoir (22) étant configuré, en décharge, pour alimenter le module de pilotage (14) en énergie électrique.

3. Dispositif de commutation de puissance (10) selon la revendication 2, dans lequel le module de pilotage (14) comprend une alimentation auxiliaire, configurée pour participer au moins en partie au démarrage du module de pilotage (14).

4. Dispositif de commutation de puissance (10) selon la revendication 2 ou 3, dans lequel le dispositif comprend en outre un module de régulation (24) configuré pour réguler, en décharge, la valeur de l'énergie électrique délivrée par le réservoir (22) au module de pilotage (14).

5. Dispositif de commutation de puissance (10) selon la revendication 4, dans lequel le module de régulation (24) comprend un régulateur linéaire.

6. Dispositif de commutation de puissance (10) selon la revendication 4, dans lequel le module de régulation (24) comprend une alimentation à découpage.

7. Dispositif de commutation de puissance (10) selon l'une quelconque des revendications précédentes, dans lequel le module de contrôle de tension (26) est configuré pour commuter le réservoir (22) en charge lorsque la tension principale (U_{c}) mesurée est supérieure à la tension nominale (U_{N}) et en décharge lorsque la tension principale (U_{c}) mesurée est inférieure à la tension nominale (U_{N}).

8. Dispositif de commutation de puissance (10) selon l'une quelconque des revendications précédentes, dans lequel le dispositif comprend en outre un interrupteur (28) agencé en série du réservoir (22) et dans lequel la commutation entre la charge et la décharge du réservoir (22) par le module de contrôle de tension (26) correspond à une modification d'une position de l'interrupteur (28) entre une position fermée et une position ouverte.

9. Dispositif de commutation de puissance (10) selon l'une quelconque des revendications précédentes, dans lequel, en charge, le réservoir (22) est agencé parallèlement au transistor (12).

10. Procédé de commutation (100) d'un réservoir (22) d'un dispositif de commutation de puissance (10) entre un état en charge et un état en décharge, le dispositif de commutation de puissance (10) comprenant :
- un transistor (12) du type SiC ou GaN MOSFET présentant à ses bornes une tension principale (U_{c}),
- un circuit de protection (16) comprenant :
- un module d'écrêtage (18) configuré pour écrêter la tension principale (U_{c}) lorsque le transistor est en surtension et lorsque la tension principale (U_{c}) dépasse alors une tension nominale (U_{N}) prédéterminée;
- un module de mesure (20) configuré pour mesurer la tension principale (U_{c}) aux bornes du transistor (12),
- le réservoir (22) configuré, en charge, pour stocker l'énergie de surtension du transistor (12) et, en décharge, pour délivrer l'énergie de surtension du transistor (12), et
- un module de contrôle de tension (26) configuré pour commuter le réservoir (22) entre charge et décharge,
le procédé comprenant les étapes suivantes :
- mesure (110) de la tension principale (Uc) aux bornes d'un transistor (12) par le module de mesure (20) ;
- comparaison (120), par le module de contrôle de tension (26) de la tension principale (U_{c}) mesurée à la tension nominale prédéterminée (U_{N}) du transistor (12) ;
- si la tension principale (U_{c}) mesurée est supérieure à la tension nominale (U_{N}), activation de la charge (130) du réservoir (22), par le module de contrôle de tension (26) et, simultanément à la charge (130) du réservoir (22), écrêtage (140) de la tension principale (U_{c}) à une tension d'écrêtage (U_{ecr}), par le module d'écrêtage (18) ;
- si la tension principale (U_{c}) est inférieure à la tension nominale (U_{N}), activation de la décharge (140) du réservoir (22), par le module de contrôle de tension (26).
